# EUROPEAN PATENT APPLICATION

(11) **EP 0 600 365 A1**
(43) Date of publication of application: **08.06.1994**
(21) Application number: 93118926.0
(22) Date of filing: 24.11.1993
(51) Int. Cl.: H01J 37/32

(54) **Electrode for use in plasma etching**

(30) Priority: 02.12.1992 JP 350446/92
(71) Applicant: NISSHINBO INDUSTRIES, INC., Chuo-ku, Tokyo 103 (JP)
(72) Inventor: Saito, Kazuo, c/o Nisshinbo Industries, Inc., Adachi-ku, Tokyo 123 (JP); Ishimatsu, Takeshi, c/o Nisshinbo Industries, Inc., Adachi-ku, Tokyo 123 (JP)
(74) Representative: Laufhütte, Dieter, Dr.-Ing.

(57) **Abstract**

The present invention provides an electrode for use in plasma etching, composed of a silicon single crystal or a silicon single crystal having a large number of small through-holes.

The electrode of the present invention is free from structural destruction, resultantly has a long life, and causes no staining of wafer surface owing to structural destruction. Further, when the electrode has an appropriate number of small through-holes, a reactant gas can flow into a plasma smoothly and enables more efficient plasma etching.

## Description

### Background of the Invention

### (1) Field of the Invention

The present invention relates to an electrode for use in plasma etching, which is used for production of a semiconductor integrated circuit such as IC, LSI or the like. More particularly, the present invention relates to an electrode for use in plasma etching, which is used for production of such a semiconductor integrated circuit by plasma etching.

### (2) Prior Art

With the recent progress of the techniques for production of finer and more dense semiconductor integrated circuit, there has become increasingly important the plasma etching capable of forming a fine pattern on a wafer with high precision using parallel plate electrodes.

The material for the electrodes used in said plasma etching must have not only a high purity but also other properties such as electrical conductivity, chemical stability and the like. As the material, there have been mainly used metal plates such as stainless steel plate and the like. These metal plates have problems of (1) insufficient chemical stability and (2) difficulty of producing them in a high purity.

Hence, it was tried to use high-density graphite in place of the electrode made of a metal plate. This high-density graphite has excellent chemical stability and can be easily produced in a high purity, and is therefore preferable as a material for electrode for use in plasma etching. However, since this material is produced by mixing a coke or carbon powder with a binder (e.g., tar or pitch), molding the mixture and carbonizing the molded material to graphitize it, the material, when molded into an electrode and fitted in a plasma etching apparatus to conduct the plasma etching of a wafer, causes the detaching of fine carbon particles from the electrode, which accelerates the consumption of the electrode or stains the wafer (this hinders pattern formation).

Japanese Patent Application Kokai (Laid-Open) No. 252942/1987 discloses an electrode for use in plasma etching comprising a high-purity vitreous carbon. This vitreous carbon has excellent impermeability to gas and a high hardness and is therefore excellent as a material for electrode for use in plasma etching. It is known, however, that this material, when used as an electrode in plasma etching of a wafer, stains the wafer because of the carbon atoms sputtered by a plasma, or causes the detaching of carbon particles owing to the defects present inside the electrode, such as gaps, pores and the like. Therefore, the material cannot be made into a satisfactory electrode for use in plasma etching.

### Summary of the Invention

The present invention has been made in order to solve the above-mentioned problems of the prior arts and is intended to provide an electrode for use in plasma etching, having satisfactory properties in purity, chemical stability, etc., and satisfactory performances (e.g., causing no structural destruction).

According to the present invention, there is provided an electrode for use in plasma etching, composed of a silicon single crystal or a silicon single crystal having an appropriate number of small through-holes.

The present inventors made investigations on materials usable as an electrode for use in plasma etching and made experiments particularly on a silicon single crystal being used as IC substrates. As a result, the present inventors found that a silicon single crystal satisfies the above-mentioned properties and performances required for the electrode for use in plasma etching. Further experiments have led to the completion of the present invention.

### Detailed Description of the Invention

The present invention is described in detail below.

The silicon single crystal used in the present invention may be any silicon single crystal used in ordinary IC substrates and semiconductor elements, and has no particular restriction. Such a silicon single crystal can be produced generally by melting silicon in a quartz crucible and, with rotating the crucible, growing a silicon single crystal while pulling up the formed silicon single crystal in the presence of seed crystals.

The above-obtained silicon single crystal is sliced into a plate of desired size, whereby an electrode for use in plasma etching according to the present invention can be produced. Therefore, the electrode for use in plasma etching according to the present invention is preferably disc-shaped and has a diameter of, for example, 2-50 cm, preferably 10-30 cm.

The above silicon single crystal may have an appropriate number of small through-holes so as to enable, in plasma etching, the smooth flow of reactant gas into plasma via said through-holes. Such small through-holes can be formed by means of discharging, ultrasonic wave or the like.

The small through-holes are formed so that they are uniformly or substantially uniformly distributed in the present electrode. The diameters of the through-holes are, for example, 0.1-5 mm, and the number thereof is, for example, 100-50,000 in the case of an electrode having a diameter of 20 cm.

When the present electrode has no small through-holes, it is preferable to allow a reactant gas or the like to flow parallel to the electrode plane during plasma etching.

The thus-produced electrode of the present invention for use in plasma etching, composed of a silicon single crystal is not an agglomerate of particles but a complete single crystal containing a very small amount of impurities. Therefore, it has a high purity, a high precision and high chemical stability.

Further, the present electrode for use in plasma etching, being composed of a single crystal, gives rise to no structural destruction during use, is very low in consumption, and consequently is an ideal electrode for use in plasma etching.

### Example 1

A silicon single crystal having a diameter of 20 cm was sliced into a disc having a thickness of 3 mm. An ultrasonic wave was applied to the disc plane to form 7,500 through-holes each of 0.5 mm in diameter substantially uniformly in the plane. The resulting silicon single crystal was set in a plasma etching apparatus, as an electrode. A reactant gas, i.e., a mixed gas of CHF₃, Ar and O₂ was passed through the apparatus to etch a silicon wafer. The time in which the initial thickness of 3 mm was reduced to a residual thickness of 0.5 mm, was taken as the life of the electrode.

As a result, the electrode of the present invention for use in plasma etching had a life of 1,500 hours. Moreover, the electrode showed no structural destruction during long use.

### Examples 2-7

Six electrodes of the present invention for use in plasma etching were produced in the same manner as in Example 1, except that the diameter and number of through-holes were changed. Etching of silicon wafer was conducted in the same manner as in Example 1 to measure the life of each electrode. The results are shown in Table 1.

**Table 1**

| Example | Dia. of small through-holes (mm) | Number of small through-holes | Life of electrode (hr) |
|---|---|---|---|
| 2 | 0.2 | 20,000 | 1,500 |
| 3 | 0.8 | 1,700 | 2,000 |
| 4 | 2 | 1,100 | 1,800 |
| 5 | 4 | 200 | 1,900 |
| 6 | 0.5 | 3,000 | 1,800 |
| 7 | 0.5 | 500 | 2,000 |

### Comparative Example 1

A vitreous carbon plate of 3 mm in thickness was subjected to the same processing as in Example 1 to produce an electrode for plasma etching. The electrode was subjected to the same measurement as in Example 1. As a result, the electrode had a life of 600 hours and showed partial destruction of structure.

### Comparative Example 2

A high-density graphite of 3 mm in thickness was subjected to the same processing as in Example 1 to produce an electrode for plasma etching. The electrode was subjected to the same measurement as in Example 1. As a result, the electrode had a life of 300 hours and showed structural destruction at a number of places.

As stated above, the present electrode for use in plasma etching, composed of a silicon single crystal is free from structural destruction (e.g., detaching of particles), resultantly has a long life (this gives an improved yield of electrode), and causes no staining of wafer surface owing to structural destruction.

Further, when the present electrode has an appropriate number of small through-holes, a reactant gas can flow into a plasma smoothly and enables more efficient plasma etching.

## Claims

1. An electrode for use in plasma etching, composed of a silicon single crystal.

2. An electrode for use in plasma etching, composed of a silicon single crystal having an appropriate number of small through-holes.

3. An electrode for use in plasma etching according to Claim 2, wherein the small through-holes have a diameter of 0.1-5 mm.
